# EUROPEAN PATENT SPECIFICATION

(11) **EP 3 415 929 B1**
(45) Date of publication and mention of the grant of the patent: **03.08.2022**
(21) Application number: 17305718.3
(22) Date of filing: 13.06.2017
(51) Int. Cl.: G01R 15/16, G01R 15/06

(54) **ELECTRICAL ACCESSORY COMPRISING A SENSING ELEMENT OF VOLTAGE ON A CABLE**
ELEKTRISCHES ZUBEHÖR MIT EINEM MESSELEMENT DER SPANNUNG AN EINEM KABEL
ACCESSOIRE ÉLECTRIQUE COMPRENANT UN ÉLÉMENT DE DÉTECTION DE TENSION SUR UN CÂBLE

(43) Date of publication of application: 19.12.2018
(73) Proprietor: Nexans, 92400 Courbevoie (FR)
(72) Inventor: CARDINAELS, Jozef, 9230 Wetteren (BE); WEYGAERTS, Kevin, 9310 Meldert (BE); PARRA, Angèle, 1060 Saint Gilles (BE); DE RIDDER, Eduard, 9310 Herdersem-Aalst (BE); STUL, Simon, 9040 Sint-Amandsberg (BE)
(74) Representative: Ipsilon

(56) References cited:
- WO-A1-2016/187090
- DE-A1- 19 653 792
- US-A- 4 868 711
- TONIS HOBEJOGI ET AL: "Coaxial capacitive voltage divider with high division ratio for high voltage pulses with very fast rise times", PULSED POWER CONFERENCE (PPC), 2011 IEEE, IEEE, 19 June 2011 (2011-06-19), pages 313-318, XP032172824, DOI: 10.1109/PPC.2011.6191436 ISBN: 978-1-4577-0629-5
- GONZALEZ CARLOS ET AL: "Dynamic Thermal Modeling of Voltage Divider Capacitive Coupling", IEEE TRANSACTIONS ON POWER DELIVERY, IEEE SERVICE CENTER, NEW YORK, NY, US, vol. 31, no. 3, 1 June 2016 (2016-06-01), pages 1015-1025, XP011610896, ISSN: 0885-8977, DOI: 10.1109/TPWRD.2015.2392386 [retrieved on 2016-05-20]

## Description

The invention concerns an electrical accessory comprising a sensing element for determining a voltage on a conductor passing through said electrical accessory.

To know a voltage on a cable, a voltage measurement may be performed directly on the conductor. However, when the conductor is at high voltage, a direct measurement on the conductor is difficult and expensive.

It is thus known in the art to perform an indirect measurement of the voltage by using a capacitive voltage divider so as to make this measurement easier and less expensive.

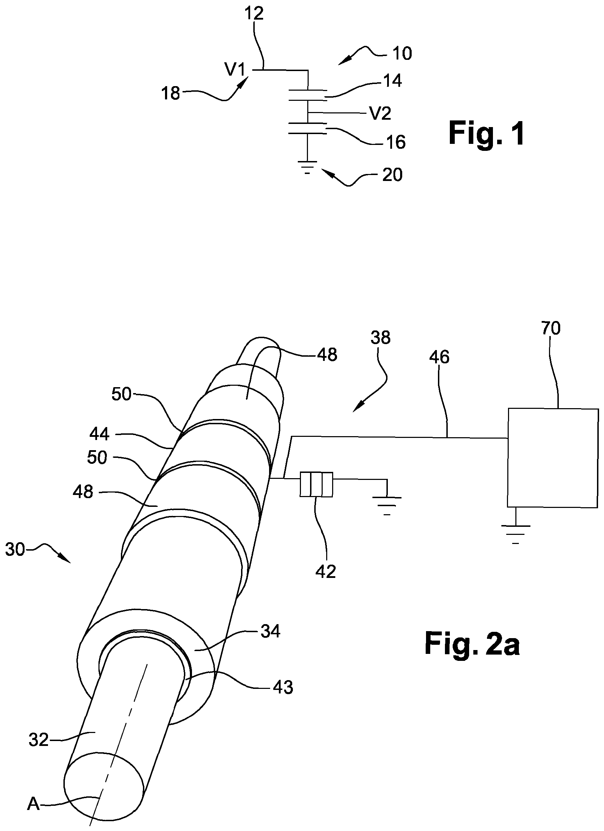

As shown in figure 1, a capacitive voltage divider 10 comprises a branch 12 on which a first capacitor 14 and a second capacitor 16 are disposed in series. A first end 18 of the branch 12 is at a first voltage V1 and a second end 20 opposed to the first end 18 is grounded. In this electrical arrangement, the first voltage V1 may be calculated depending on the first 14, the second 16 capacitor and the second voltage V2. As a consequence, knowing the capacitance of the first 14 and the second 16 capacitor, the capacitive voltage divider 10 allows to calculate or estimate the first voltage V1 by measuring the second voltage V2 across the second 16 capacitor. Furthermore, in a high voltage application, the capacitance of the first 14 and second 16 capacitor may be chosen so that the second voltage V2 is low and easy to measure. In this regard, if the first end 18 is electrically connected to a conductor of a cable at high voltage, providing the cable with a suitable arrangement forming a capacitive voltage divider 10 allows to calculate or estimate the high voltage on the conductor by only measuring the low voltage across second 16 capacitor.

The document WO2016/187090 describes a voltage sensor to be connected to a power line by way of a connection interface in which a capacitive voltage divider is formed. The voltage sensor comprises a sensor section with a conductor at a high voltage and a single or multiple insulating layers disposed around the conductor. The insulating layer is for example made of elastomeric silicone. The sensor section also comprises an electrically isolated conductive layer, or LV electrode, disposed around the insulating layer forming a first capacitive element. By adding a second capacitive element connected to the LV electrode of the first capacitive element, a capacitive voltage divider is formed.. The arrangement of the sensor section as a capacitive voltage divider allows to measure the low voltage at the electrically isolated layer and then estimate the high voltage on the conductor. The voltage of the power line can thus be determined because it is directly proportional to the voltage across the second capacitive element of the divider.

A major drawback of such a voltage sensor is that it is not very accurate since the properties of an insulating layer made of a specific material (for example elastomeric silicone) and having a high thickness, since it has to withstand the electrical stresses resulting from the high voltage on the conductor, vary with temperature. When temperature changes within an intended range of use (e.g. from -20°C to 90°C) the dielectric constant, or relative permittivity, of some materials such as the elastomeric silicone varies, making the estimation of the conductor voltage inaccurate. Indeed, a dielectric constant may vary more than 10% from its initial value when temperature changes within the intended range of use.

In the case of a capacitor formed by an insulating layer, the dielectric constant of a material from which the insulating layer is made, together with its dimensions (surface area of the electrodes and thickness of the insulating material) determine the capacitance of this capacitor. Consequently, when the dielectric constant of an insulating layer forming a capacitor varies due to the temperature, the capacitance of said capacitor also varies thereby rendering any calculation or estimation based on a capacitance value of the capacitor inaccurate, if the dielectric constant variation is not taken into account.

Furthermore, due to the linear coefficient of expansion of materials, also the dimensions change when temperature varies.

The temperature dependency of the dielectric constant therefore is crucial for the usability of a material in such applications.

Materials having dielectric constant with very low temperature dependency coefficient are known, such as polysulfone, polyester, polyimide, but such materials are difficult to use in high voltage applications.

On materials commonly used in HV applications, 2 types of behavior have been observed: materials having a dielectric constant with positive temperature dependency coefficient, meaning dielectric constant increases with increasing temperature, and materials having a dielectric constant with negative temperature dependency coefficient, meaning dielectric constant decreases with increasing temperature.

An object of the present invention is to provide an electrical accessory with a voltage sensor able to determine the voltage on a conductor of a cable with an improved accuracy even when temperature variations occur.

To solve this problem, the invention provides an electrical accessory comprising:
- a tubular conductor through which a current-carrying conductor can pass ;
- at least one insulating layer disposed around the tubular conductor;
- a voltage sensing element forming a capacitive voltage divider to determine a voltage on the current-carrying conductor, comprising:
   - a first capacitor formed by the at least one insulating layer;
   - a second capacitor electrically connected to a ground potential and to the first capacitor;
characterized in that the first capacitor comprises at least two insulating layers having a dielectric constant whose temperature dependency coefficient has opposite signs with respect to each other.

Forming a capacitor with at least two insulating layers having dielectric constants with temperature dependency coefficients with opposite signs with respect to each other makes it possible to reduce the temperature dependency coefficient of this capacitor when temperature changes within an intended range of use (e.g. from -20°C to 90°C). Indeed, the variation of the dielectric constant of one of the insulating layers may be compensated by the variation of the dielectric constant of the other. If materials are suitably chosen and the relative material thicknesses well determined, even the influence of the dimensional variations due to temperature on the capacitance value can be compensated. Thus, a variation of the dielectric constant of the first capacitor due to a change in temperature within the intended range of use may be adjusted by choosing appropriate materials for the two insulating layers. In this manner, even if a first material having a dielectric constant with first temperature dependency coefficient, whether positive or negative, is used in a first insulating layer for a specific purpose (e.g. its ability to withstand electrical stresses), a second insulating layer may be made of a second material with a dielectric constant with second temperature dependency coefficient, positive or negative, with an opposite sign with regard to the first temperature dependency coefficient so as to adjust or compensate the variation of the first insulating layer. In doing so, the temperature dependency coefficient of the first capacitor may be reduced to have an accuracy better than with providing the first capacitor only with a single insulating layer or with multiple insulating layers of unmatched temperature dependency coefficients. Typically the variation may be reduced from over 10% to well below 1%.

According to another embodiment of the electrical accessory, one of the insulating layers is made of a material whose dielectric constant has a positive temperature dependency coefficient, another one of the insulating layers being made of a material having a dielectric constant with negative temperature dependency coefficient.

According to another embodiment of the electrical accessory, the material having a dielectric constant with positive temperature dependency coefficient is one among : an epoxy resin filled with quartz flour, polyethylene terephthalate and cross-linked polyethylene, the material having a dielectric constant with negative temperature dependency coefficient being one among : silicone rubber and ethylene propylene diene monomer.

According to another embodiment of the electrical accessory, the material having a dielectric constant with positive temperature dependency coefficient is an epoxy resin filled with quartz flour and the material having a dielectric constant with negative temperature dependency coefficient is silicone rubber.

According to another embodiment of the electrical accessory, the insulating layer with a dielectric constant having a positive temperature dependency coefficient comprises a first radial dimension greater than a second radial dimension of the insulating layer with a dielectric constant having a negative temperature dependency coefficient

By providing the insulating layer with a material whose dielectric constant has a positive temperature dependency coefficient having a thickness greater than the insulating layer with a material whose dielectric constant has a positive temperature dependency coefficient, the electrical accessory is able to compensate the variations of the two insulating layers more precisely.

According to an embodiment of the electrical accessory, the first radial dimension is between 4 and 8 times, preferably between 5 and 7 times, preferably 6 times, greater than the second radial dimension.

According to another embodiment of the electrical accessory, the second insulating layer is disposed around the first insulating layer, the first capacitor comprising:
- a high-voltage electrode formed by the tubular conductor and the first and second insulating layers; and
- a low-voltage electrode formed around the second insulating layer.

According to another embodiment of the electrical accessory, the high-voltage electrode is formed by a conductive tube disposed around the current-carrying conductor.

According to another embodiment, the electrical accessory further comprises a grounded layer around the second insulating layer, an electrically separated portion of the grounded layer forming the low-voltage electrode.

According to another embodiment of the electrical accessory, at least one interruption is formed on the grounded layer to form the electrically separated portion.

According to another embodiment, the electrical accessory further comprises a printed circuit board disposed close to the first capacitor, the second capacitor being installed on the printed circuit board.

According to another embodiment, the electrical accessory further comprises a protecting sleeve covering the voltage sensing element.

According to another embodiment, the electrical accessory forms a termination of a cable, a connector for connecting a cable to equipment or an independent sensing module to be connected to a power line.

According to another embodiment, the electrical accessory is a high voltage electrical accessory.

The invention is described in more detail below by way of the figures that show only one preferred embodiment of the invention.
Figure 1 is an electrical diagram of a capacitive voltage divider.
Figure 2a is a schematic perspective view of the electrical accessory according to an embodiment of the invention.
Figure 2b is a schematic cross-sectional view of the electrical accessory of figure 2a.
Figure 3 is a simplified cross-sectional view illustrating the electrical accessory equipped with additional elements to build a fully-equipped cable terminating device.
Figure 4 is a perspective view of an electrical accessory fully equipped to build a termination of a high voltage cable.

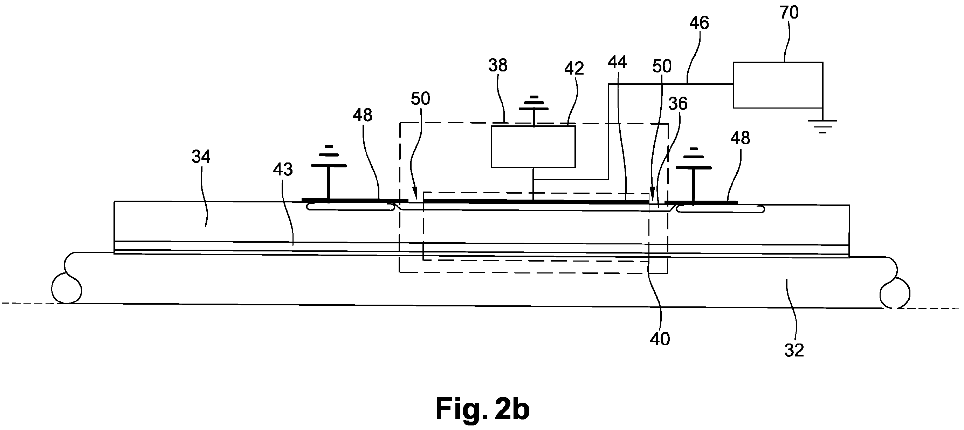

As shown on figures 2a and 2b, an embodiment of the invention concerns an electrical accessory 30 being a tubular structure to be installed over a current-carrying conductor 32 that is operating at high voltage, i.e. above 1000 V AC. The electrical accessory 30 comprises a tubular conductor 43 through which the current-carrying conductor 32 can pass. Connecting means may be provided to make electrical contact between the tubular conductor 43 and the current-carrying conductor 32. Preferably, the tubular conductor 43 contacts the current-carrying conductor 32. The electrical accessory 30 further comprises a first insulating layer 34 and a second insulating layer 36 both disposed around the tubular conductor 43. Particularly, the second insulating layer 36 is preferably disposed around the first insulating layer 34. The tubular conductor 43 and the first 34 and second 36 insulating layers are generally circular and extend along a longitudinal axis A.

The electrical accessory 30 also comprises a voltage sensing element 38 formed around the tubular conductor 43 so as to make the electrical accessory 30 able to determine or estimate a voltage on the current-carrying conductor 32. The voltage sensing element 38 is formed as a capacitive voltage divider to determine the voltage on the current-carrying conductor 32. Particularly, the voltage sensing element 38 is formed as the capacitive voltage divider 10 shown on figure 1. The voltage sensing element 38 comprises a first capacitor 40 formed by the first 34 and second 36 insulating layers and a second capacitor 42 electrically connected to a ground potential. The second capacitor 42 is also electrically connected to the first capacitor 40. In other words, the first 40 and second 42 capacitors are electrically connected in series between the current-carrying conductor 32 and a ground potential. The second capacitor 42 is preferably a conventional capacitor with low temperature dependency coefficient mounted onto a printed circuit board. A temperature dependency coefficient is considered to be low when the capacity of a capacitor changes below 1%, preferably below 0.5%, most preferably below 0.1% when temperature changes within an intended range of use (from -20°C to 90°C).

The voltage sensing element 38 can be connected to a readout structure 70 to measure a voltage across the second 42 capacitor so as to determine the voltage on current-carrying conductor 32. As indicated above, a capacitive voltage divider enables to determine or estimate the voltage current-carrying conductor 32 by measuring the voltage across second capacitor 42.

The first capacitor 40 preferably comprises a high-voltage electrode 43 formed by a part of the tubular conductor 43 and first 34 and second 36 insulating layers as well as a low-voltage electrode 44 formed around the second insulating layer 36. The high-voltage electrode 43 is formed by a conductive tube disposed around the current-carrying conductor 32. The electrical accessory 30 also comprises a grounded layer 48 disposed around the second insulating layer 36. Preferably, the grounded layer 48 contacts the second insulating layer 36. The grounded layer 48 extends along the longitudinal axis A, preferably on a portion only of the accessory formed by the tubular conductor 43 and the first 34 and second 36 insulating layers.

The low voltage electrode 44 of the voltage sensor is electrically separated from the grounded layer 48. To form the electrically separated portion, two interruptions 50 are formed on the grounded layer 48. Particularly, the two interruptions 50 do not intersect each other and extend transversally to the longitudinal axis A of the grounded layer 48. In this manner, the two interruptions 50 physically separate a generally cylindrical portion of the grounded layer 48. In general, the electrically separated portion of the grounded layer 48 may be formed by any shape or recess performed on the grounded layer 48 provided that a portion is electrically separated from the rest of the grounded layer 48 to form the low-voltage electrode 44. For example, the portion may be formed by only one interruption forming a loop extending transversally to the longitudinal axis A of the grounded layer 48. Thus, at least one interruption may be provided to form the portion.

The grounded layer 48 may be formed as a sleeve disposed around the second insulating layer 36 or as a conductive paint or by any other material allowing to form the low-voltage electrode 44. The grounded layer 48 may be made of a semi-conductive material.

The first 34 and second 36 insulating layers have a dielectric constant whose temperature dependency coefficient has opposite signs with respect to each other so that a variation of the dielectric constant of the first capacitor 40 due to a change in temperature within an intended range of use (e.g. from -20°C to 90°C) may be minimized. In other words, one of the first 34 and second 36 insulating layers is made of a material whose dielectric constant has a positive temperature dependency coefficient while another one of the first 34 and second 36 insulating layers is made of a material having a dielectric constant with negative temperature dependency coefficient.

The material having dielectric constant with positive temperature dependency coefficient in the intended range of use is for example an epoxy resin filled with quartz flour, polyethylene terephthalate (also called PET) and cross-linked polyethylene (also called XLPE). The material having a dielectric constant with negative temperature dependency coefficient in the intended range of use is for example silicone rubber and Ethylene Propylene Diene Monomer (also called EPDM). In a preferred embodiment, the material having a dielectric constant with positive temperature dependency coefficient is an epoxy resin filled with quartz flour and the material having a dielectric constant with negative temperature dependency coefficient is silicone rubber. In this preferred embodiment, the first insulating layer 34 is made of epoxy resin filled with quartz flour and the second insulating layer 36 is made of silicone rubber. Moreover, as shown on figure 2b, the second insulating layer 36 may not extend along the entire length of the first insulating layer 34 but only at the low-voltage electrode 44 and possibly extending only left or right of the low-voltage electrode 44.

In a preferred embodiment, the insulating layer having a dielectric constant with positive temperature dependency coefficient comprises a first radial dimension greater than a second radial dimension of the insulating layer with a dielectric constant with negative temperature dependency coefficient. The first and second radial dimensions are defined with respective to the longitudinal axis A of the first 34 and second 36 insulating layers. In other words, the first and second radial dimensions correspond to the thickness of the first 34 and second 36 insulating layers, respectively. The first radial dimension may be between 4 and 8 times, preferably between 5 and 7 times, preferably 6 times, greater than the second radial dimension.

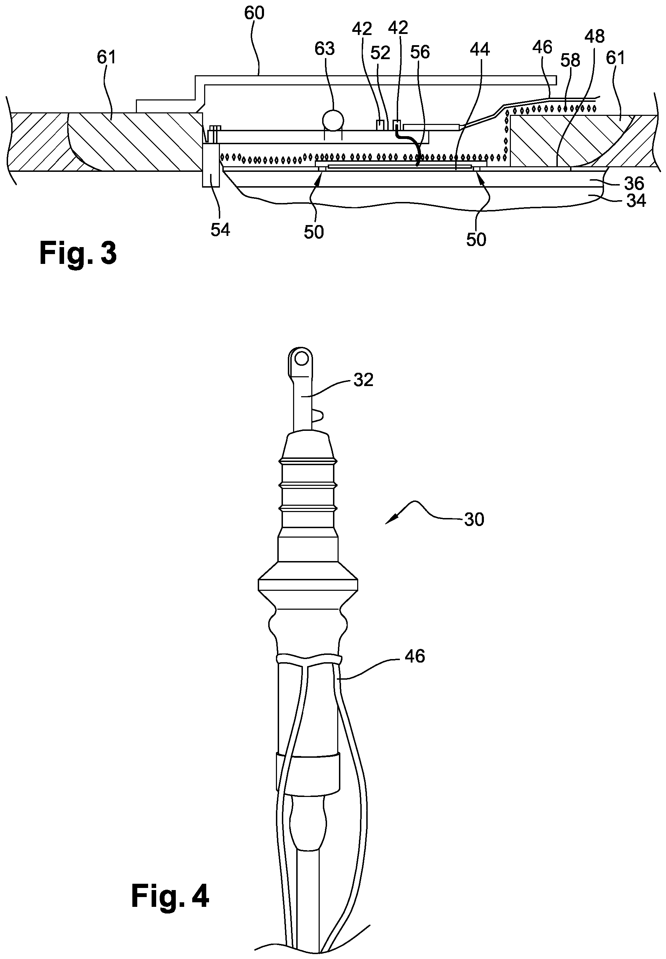

As shown in figure 3, the voltage sensing element 38 may comprise a printed circuit board (also called PCB) 52 disposed close to the low-voltage electrode 44. In this case, the second capacitor 42 is mounted onto the PCB 52 and is electrically connected to the low-voltage electrode 44 by means of a wire connection 56. A ground connection 54 is fixed to the PCB 52 to be electrically connected to the ground electrode of the second capacitor 42. The electrical connection 46 comprises a cable that may be connected to a readout module 70 able to display voltage measurement or a control module able to determine or estimate the voltage on the current-carrying conductor 32 depending on the measurement of the voltage across the second capacitor 42. Furthermore, a conductive mesh 58 disposed between the PCB 52 and the grounded layer 48 may be provided. The conductive mesh 58 is preferably made of copper. An insulating sleeve may be disposed onto the outer surface of the low-voltage electrode 44 and a conductive layer may also be applied on the insulating sleeve. The conductive layer is preferably made semi-conductive paint and the insulating sleeve is preferably made of silicone. The insulating sleeve preferably extends so as to cover the interruptions 50 of the grounded layer 48.

In a preferred embodiment, an inner air insulating layer may be formed between the current-carrying conductor 32 and the high-voltage electrode 43 to reduce the effects of an increase in temperature on the first capacitor 40. In the same purpose, a cast resin insulating layer may be formed around the second capacitor 42 inside a protecting sleeve 60 covering the voltage sensing element 38.

Moreover, the electrical accessory 30 may be further equipped with elements 61 to manage the electrical stresses at the ends of the ground layer such as stress cones or shielded connectors or any other suitable means commonly known to connect HV cables.

Additionally, the accessory may be equipped with a current sensor, such as a Rogowski coil 63, embedded in the same structure and connected to the PCB, allowing the measurement of current flowing through the current-carrying conductor 32.

As shown on figure 4, a termination of a high voltage cable may be built with a fully equipped electrical accessory 30 as shown on figure 3.

The electrical accessory may form a termination of a cable, for example by being further equipped, a separable connector for connecting a cable to an equipment, a joint between two cables or an independent sensing module to be connected to a power line, for example an air-insulated power line.

## Claims

1. An electrical accessory (30) comprising:
- a tubular conductor (43) through which a current-carrying conductor (32) can pass ;
- at least one insulating layer (34, 36) disposed around the tubular conductor (43);
- a voltage sensing element (38) forming a capacitive voltage divider to determine a voltage on the current-carrying conductor (32), comprising:
• a first capacitor (40) formed by the at least one insulating layer (34, 36) ;
• a second capacitor (42) electrically connected to a ground potential and to the first capacitor (40);
**characterized in that** the first capacitor (40) comprises at least two insulating layers (34, 36) having a dielectric constant whose temperature dependency coefficient has opposite signs with respect to each other.

2. An electrical accessory (30) according to claim 1, wherein one (34) of the insulating layers (34, 36) is made of a material whose dielectric constant has a positive temperature dependency coefficient, another one (36) of the insulating layers (34, 36) being made of a material having a dielectric constant with negative temperature dependency coefficient.

3. An electrical accessory (30) according to claim 2, wherein the material having a dielectric constant with positive temperature dependency coefficient is one among: an epoxy resin filled with quartz flour, polyethylene terephthalate and cross-linked polyethylene, the material having a dielectric constant with negative temperature dependency coefficient being one among: silicone rubber and ethylene propylene diene monomer.

4. An electrical accessory (30) according to claim 2 or 3, wherein the material having a dielectric constant with positive temperature dependency coefficient is an epoxy resin filled with quartz flour and the material having a dielectric constant with negative temperature dependency coefficient is silicone rubber.

5. An electrical accessory (30) according to any one of claims 2 to 4, wherein the insulating layer (34) with a dielectric constant having a positive temperature dependency coefficient comprises a first radial dimension greater than a second radial dimension of the insulating layer (36) with a dielectric constant having a negative temperature dependency coefficient.

6. An electrical accessory (30) according to claim 5, wherein the first radial dimension is between 4 and 8 times, preferably between 5 and 7 times, preferably 6 times, greater than the second radial dimension.

7. An electrical accessory (30) according to any one of claims 1 to 6, wherein the second insulating layer (36) is disposed around the first insulating layer (34), the first capacitor (40) comprising:
- a high-voltage electrode (43) formed by the tubular conductor (43) and the first and second insulating layers (34,36); and
- a low-voltage electrode (44) formed around the second insulating layer (36).

8. An electrical accessory (30) according to claim 7, wherein the high-voltage electrode (43) is formed by a conductive tube disposed around the current-carrying conductor (32).

9. An electrical accessory (30) according to claim 7 or 8, further comprising a grounded layer (48) around the second insulating layer (36), an electrically separated portion of the grounded layer (48) forming the low-voltage electrode (44).

10. An electrical accessory (30) according to claim 9, wherein at least one interruption (50) is formed on the grounded layer (48) to form the electrically separated portion.

11. An electrical accessory (30) according to any one of claims 7 to 10, further comprising a printed circuit board (52) disposed close to the first capacitor (40), the second capacitor (42) being installed on the printed circuit board (52).

12. An electrical accessory (30) according to any one of the preceding claims, further comprising a protecting sleeve (60) covering the voltage sensing element (38).

13. An electrical accessory (30) according to any of the preceding claims, wherein the electrical accessory (30) forms a termination of a cable, a connector for connecting a cable to equipment or an independent sensing module to be connected to a power line.

14. An electrical accessory (30) according to any of the preceding claims, wherein the electrical accessory (30) is a high voltage electrical accessory.

## Patentansprüche

1. Elektrisches Zubehörteil (30), Folgendes umfassend:
- einen röhrenförmigen Leiter (43), durch den ein stromführender Leiter (32) verlaufen kann,
- mindestens eine Isolationsschicht (34, 36), die rings um den röhrenförmigen Leiter (43) angeordnet ist,
- ein Spannungserfassungselement (38), das einen kapazitiven Spannungsteiler bildet, um eine Spannung in dem stromführenden Leiter (32) zu bestimmen, Folgendes umfassend:
• einen ersten Kondensator (40), der durch die mindestens eine Isolationsschicht (34, 36) gebildet ist,
• einen zweiten Kondensator (42), der elektrisch mit einem Massepotential und dem ersten Kondensator (40) verbunden ist,
**dadurch gekennzeichnet, dass** der erste Kondensator (40) mindestens zwei Isolationsschichten (34, 36) mit einer elektrischen Konstante umfasst, deren Temperaturabhängigkeitskoeffizienten im Verhältnis zueinander entgegengesetzte Vorzeichen aufweisen.

2. Elektrisches Zubehörteil (30) nach Anspruch 1, wobei eine (34) der Isolationsschichten (34, 36) aus einem Material besteht, dessen dielektrische Konstante einen positiven Temperaturabhängigkeitskoeffizienten aufweist, die andere (36) der Isolationsschichten (34, 36) aus einem Material besteht, das eine dielektrische Konstante mit negativem Temperaturabhängigkeitskoeffizienten aufweist.

3. Elektrisches Zubehörteil (30) nach Anspruch 2, wobei das Material, das eine dielektrische Konstante mit positivem Temperaturabhängigkeitskoeffizienten aufweist, eines des Folgenden ist: ein Epoxidharz, gefüllt mit Quarzmehl, Polyethylenterephthalat und vernetztes Polyethylen, wobei das Material, das eine dielektrische Konstante mit negativem Temperaturabhängigkeitskoeffizienten aufweist, eines des Folgenden ist: Silikonkautschuk und Ethylenpropylendienmonomer.

4. Elektrisches Zubehörteil (30) nach Anspruch 2 oder 3, wobei das Material, das eine dielektrische Konstante mit positivem Temperaturabhängigkeitskoeffizienten aufweist, ein Epoxidharz, gefüllt mit Quarzmehl, ist und das Material, das eine dielektrische Konstante mit negativem Temperaturabhängigkeitskoeffizienten aufweist, Silikonkautschuk ist.

5. Elektrisches Zubehörteil (30) nach einem der Ansprüche 2 bis 4, wobei die Isolationsschicht (34), die eine dielektrische Konstante mit positivem Temperaturabhängigkeitskoeffizienten aufweist, eine erste radiale Abmessung umfasst, die größer ist als eine zweite radiale Abmessung der Isolationsschicht (36) ist, die eine dielektrische Konstante mit negativem Temperaturabhängigkeitskoeffizienten aufweist.

6. Elektrisches Zubehörteil (30) nach Anspruch 5, wobei die erste radiale Abmessung 4-bis 8-mal, vorzugsweise zwischen 5- und 7-mal, vorzugsweise 6-mal größer als die zweite radiale Abmessung ist.

7. Elektrisches Zubehörteil (30) nach einem der Ansprüche 1 bis 6, wobei die zweite Isolationsschicht (36) rings um die erste Isolationsschicht (34) angeordnet ist, wobei der erste Kondensator (40) Folgendes umfasst:
- eine Hochspannungselektrode (43), die von dem röhrenförmigen Leiter (43) und der ersten und der zweiten Isolationsschicht (34, 36) gebildet ist, und
eine Niederspannungselektrode (44), die rings um die zweite Isolationsschicht (36) gebildet ist.

8. Elektrisches Zubehörteil (30) nach Anspruch 7, wobei die Hochspannungselektrode (43) von einer leitenden Röhre gebildet ist, die rings um den stromführenden Leiter (32) gebildet ist.

9. Elektrisches Zubehörteil (30) nach Anspruch 7 oder 8, ferner eine geerdete Schicht (48) rings um die zweite Isolationsschicht (36) umfassend, wobei ein elektrisch getrennter Abschnitt der geerdeten Schicht (48) die Niederspannungselektrode (44) bildet.

10. Elektrisches Zubehörteil (30) nach Anspruch 9, wobei an der geerdeten Schicht (48) mindestens eine Unterbrechung (50) gebildet ist, um den elektrisch getrennten Abschnitt zu bilden.

11. Elektrisches Zubehörteil (30) nach einem der Ansprüche 7 bis 10, ferner eine Leiterplatte (52) umfassend, die nahe dem ersten Kondensator (40) angeordnet ist, wobei der zweite Kondensator (42) auf der Leiterplatte (52) installiert ist.

12. Elektrisches Zubehörteil (30) nach einem der vorhergehenden Ansprüche, ferner eine schützende Hülle (60) umfassend, die das Spannungserfassungselement (38) bedeckt.

13. Elektrisches Zubehörteil (30) nach einem der vorhergehenden Ansprüche, wobei das elektrische Zubehörteil (30) einen Abschluss eines Kabels, ein Verbindungsstück zum Verbinden eines Kabels mit Ausrüstung oder ein unabhängiges Erfassungsmodul, das mit einer Energieleitung zu verbinden ist, bildet.

14. Elektrisches Zubehörteil (30) nach einem der vorhergehenden Ansprüche, wobei das elektrische Zubehörteil (30) ein elektrisches Hochspannungszubehörteil ist.

## Revendications

1. Accessoire électrique (30) comprenant :
- un conducteur tubulaire (43) à travers lequel peut passer un conducteur porteur de courant (32) ;
- au moins une couche isolante (34, 36) disposée autour du conducteur tubulaire (43) ;
- un élément de détection de tension (38) formant un diviseur de tension capacitif pour déterminer une tension sur le conducteur porteur de courant (32), comprenant :
• un premier condensateur (40) formé par l'au moins une couche isolante (34, 36) ;
• un second condensateur (42) connecté électriquement à un potentiel de terre et au premier condensateur (40) ;
**caractérisé en ce que** le premier condensateur (40) comprend au moins deux couches isolantes (34, 36) présente une constante diélectrique dont le coefficient de dépendance à la température présente des signes opposés l'un par rapport à l'autre.

2. Accessoire électrique (30) selon la revendication 1, dans lequel l'une (34) des couches isolantes (34, 36) est composée d'un matériau dont la constante diélectrique présente un coefficient de dépendance à la température positif, une autre (36) des couches isolantes (34, 36) étant composée d'un matériau présentant une constante diélectrique avec un coefficient de dépendance à la température négatif.

3. Accessoire électrique (30) selon la revendication 2, dans lequel le matériau présentant une constante diélectrique avec un coefficient de dépendance à la température positif est l'un parmi : une résine époxy chargée de farine de quartz, du polyéthylène téréphtalate et du polyéthylène réticulé, le matériau présentant une constante diélectrique avec un coefficient de dépendance à la température négatif étant l'un parmi : du caoutchouc de silicone et un monomère d'éthylène propylène diène.

4. Accessoire électrique (30) selon la revendication 2 ou 3, dans lequel le matériau présentant une constante diélectrique avec un coefficient de dépendance à la température positif est une résine époxy chargée de farine de quartz et le matériau présentant une constante diélectrique avec un coefficient de dépendance à la température négatif est du caoutchouc de silicone.

5. Accessoire électrique (30) selon l'une quelconque des revendications 2 à 4, dans lequel la couche isolante (34) avec une constante diélectrique présentant un coefficient de dépendance à la température positif comprend une première dimension radiale supérieure à une seconde dimension radiale de la couche isolante (36) avec une constante diélectrique présentant un coefficient de dépendance à la température négatif.

6. Accessoire électrique (30) selon la revendication 5, dans lequel la première dimension radiale est entre 4 et 8 fois, de préférence entre 5 et 7 fois, de préférence 6 fois, supérieure à la seconde dimension radiale.

7. Accessoire électrique (30) selon l'une quelconque des revendications 1 à 6, dans lequel la seconde couche isolante (36) est disposée autour de la première couche isolante (34), le premier condensateur (40) comprenant :
- une électrode haute tension (43) formée par le conducteur tubulaire (43) et les première et seconde couches isolantes (34, 36) ; et
- une électrode basse tension (44) formée autour de la seconde couche isolante (36).

8. Accessoire électrique (30) selon la revendication 7, dans lequel l'électrode haute tension (43) est formée par un tube conducteur disposé autour du conducteur porteur de courant (32).

9. Accessoire électrique (30) selon la revendication 7 ou 8, comprenant en outre une couche mise à la terre (48) autour de la seconde couche isolante (36), une partie séparée électriquement de la couche mise à la terre (48) formant l'électrode basse tension (44).

10. Accessoire électrique (30) selon la revendication 9, dans lequel au moins une interruption (50) est formée sur la couche mise à la terre (48) pour former la partie séparée électriquement.

11. Accessoire électrique (30) selon l'une quelconque des revendications 7 à 10, comprenant en outre une carte de circuit imprimé (52) disposée près du premier condensateur (40), le second condensateur (42) étant installé sur la carte de circuit imprimé (52).

12. Accessoire électrique (30) selon l'une quelconque des revendications précédentes, comprenant en outre un manchon de protection (60) couvrant l'élément de détection de tension (38).

13. Accessoire électrique (30) selon l'une quelconque des revendications précédentes, dans lequel l'accessoire électrique (30) forme une terminaison d'un câble, un connecteur pour connecter un câble à un équipement ou un module de détection indépendant devant être connecté à une ligne électrique.

14. Accessoire électrique (30) selon l'une quelconque des revendications précédentes, dans lequel l'accessoire électrique (30) est un accessoire électrique haute tension.
